# EUROPEAN PATENT APPLICATION

(11) **EP 2 767 749 A1**
(43) Date of publication of application: **20.08.2014**
(21) Application number: 11873440.9
(22) Date of filing: 27.09.2011
(51) Int. Cl.: F21S 8/02, F21V 23/00, F21V 29/00, F21Y 101/02

(54) **LAMP AND ILLUMINATING APPARATUS**

(71) Applicant: Toshiba Lighting & Technology Corporation, Yokosuka-shi, Kanagawa 237-8510 (JP)
(72) Inventor: MATSUSHITA, Hiroshi, 237-8510 Kanagawa (JP); TAKAHARA, Yuichiro, 237-8510 Kanagawa (JP); MATSUMOTO, Shinichiro, 237-8510 Kanagawa (JP); NAKAJIMA, Hiromichi, 237-8510 Kanagawa (JP); OSAWA, Shigeru, 237-8510 Kanagawa (JP); KAMATA, Masahiko, 237-8510 Kanagawa (JP)
(74) Representative: Willquist, Sofia Ellinor
(86) International application number: PCT/JP2011/072007
(87) International publication number: WO 2013/046319

(57) **Abstract**

To make it possible to improve extracting efficiency of light while securing thermal radiation performance of a light-emitting element. According to an embodiment, a lamp main body (21), a lighting device (25), a reflecting member (24) and a light-emitting module (23) are provided. The lamp main body (21) includes a case (28) and a cap member (29) attached to the case (28). The case (28) includes an opening (28a) at one end and a hole (34) in the other end center. The cap member (29) integrally includes a projection (46) insertable into the opening (34). The lighting device (25) and the reflecting member (24) are housed in the case (28). The lighting device (25) includes a circuit board (77). The reflecting member (24) configured to reflect light to the outside of the lamp main body (21) includes a reflecting cylinder section (68) including a small-diameter opening and a large-diameter opening. The diameter of the cylinder section expands further toward the large-diameter opening side. The light-emitting module (23) includes a light-emitting element mounted on a substrate (53) and caused to emit light by the lighting device (25). The light-emitting module (23) is arranged on the projection (46) to be capable of transmitting heat to the projection (46). The heat conductivity of the substrate (53) is superior to the heat conductivity of the circuit board (77).

## Description

### Technical Field

Embodiments of the present invention relate to a lamp including a light-emitting element and a lighting device and a luminaire including the lamp.

### Background Art

There is known a lamp in which a light-emitting module, a reflecting member and a lighting circuit are arranged in a lamp main body to improve a thermal radiation property of the light-emitting module.

In this lamp, the lamp main body is made of metal. A GX53-type cap section is integrally formed in an upper part of the lamp main body. A plurality of lamp pins are attached to the lamp main body to be insulated from the lamp main body. The pins are disposed around the cap section. The light-emitting module includes a substrate and an LED mounted on the substrate. The substrate of the light-emitting module is set in contact with the inner surface of the cap section to be capable of conducting heat to the inner surface.

The reflecting member includes a reflecting surface section and a supporting plate section. The supporting plate section is fixed to a lower end circumferential edge section of the lamp main body. The reflecting surface section is opened at the upper end and the lower end thereof and is formed in a cylindrical shape having a radius expanded downward. The upper end opening of the reflecting surface section is close to the cap and surrounds the light-emitting module.

The lighting circuit for lighting the LED is disposed on the rear side of the supporting plate section to surround the reflecting surface section. Therefore, the cylindrical reflecting surface section pierces through the center of the lighting circuit in the up down direction.

A socket is attached to the lower surface of a luminaire main body made of metal. The lamp is supported by the socket. The lamp pins are inserted into the socket and the lamp main body is rotated a predetermined angle, whereby the lamp is attached to the socket. The upper surface of the cap section of the attached lamp is set in surface contact with the luminaire main body 12. Therefore, in a state in which the lamp is lit, heat generated by the LED can be conducted to the luminaire main body and emitted.

Among components configuring the lamp, a cost of the light-emitting module including the LED is markedly high compared with the other components. If extracting efficiency of light emitted by the module can be improved, an inexpensive light-emitting module can be used. Consequently, it is possible to reduce costs of the lamp and the luminaire including the lamp. In this regard, the lamp having the above-mentioned configuration has room for improvement in improving the extracting efficiency of the light emitted from the light-emitting module.

On the other hand, to maintain the light-emitting performance and the life of the LED, it is necessary to secure thermal radiation performance of the LED.

### Citation List

### Patent Literature

Patent Literature 1: JP-A-2010-262781

### Summary of Invention

### Technical Problem

An embodiment is to provide a lamp capable of improving extracting efficiency of light emitted from a light-emitting module while securing thermal radiation performance of a light-emitting element and a luminaire including the lamp.

### Solution to Problem

A lamp in an embodiment includes a lamp main body, a lighting device, a reflecting member and a light-emitting module. The lamp main body includes a case and a cap member attached to the case. The case includes an opening at one end and includes a hole in the other end center. The cap member integrally includes a projection insertable into the hole of the case. The lighting device and the reflecting member are housed in the case. The lighting device includes a circuit board. The reflecting member includes a reflecting cylinder section including a small-diameter opening and a large-diameter opening. The diameter of the reflecting cylinder section expands further toward the large-diameter opening side. The reflecting cylinder section reflects light to the outside of the lamp main body. The light-emitting module includes a light-emitting element mounted on a substrate and caused to emit light by the lighting device. The light-emitting module is arranged on the projection to be capable of transmitting heat to the projection. The heat conductivity of the substrate is superior to the heat conductivity of the circuit board.

### Brief Description of the Drawings

[Fig. 1] Fig. 1 is a perspective view showing a lamp according to a first embodiment.
[Fig. 2] Fig. 2 is a perspective view showing the lamp according to the first embodiment from a direction different from a direction in Fig. 1.
[Fig. 3] Fig. 3 is a sectional view showing the lamp according to the first embodiment.
[Fig. 4] Fig. 4 is a perspective view showing the lamp according to the first embodiment in a disassembled state.
[Fig. 5] Fig. 5 is a partially enlarged sectional view showing the lamp according to the first embodiment.
[Fig. 6] Fig. 6 is a perspective view showing a luminaire according to the first embodiment in a disassembled state of a luminaire main body and a lamp.
[Fig. 7] Fig. 7 is a sectional view showing a lamp according to a second embodiment.
[Fig. 8] Fig. 8 is a sectional view showing a lamp according to a third embodiment.
[Fig. 9] Fig. 9 is a sectional view showing a lamp according to a fourth embodiment.
[Fig. 10] Fig. 10 is a sectional view showing a lamp according to a fifth embodiment.

### Description of Embodiments

### First Embodiment

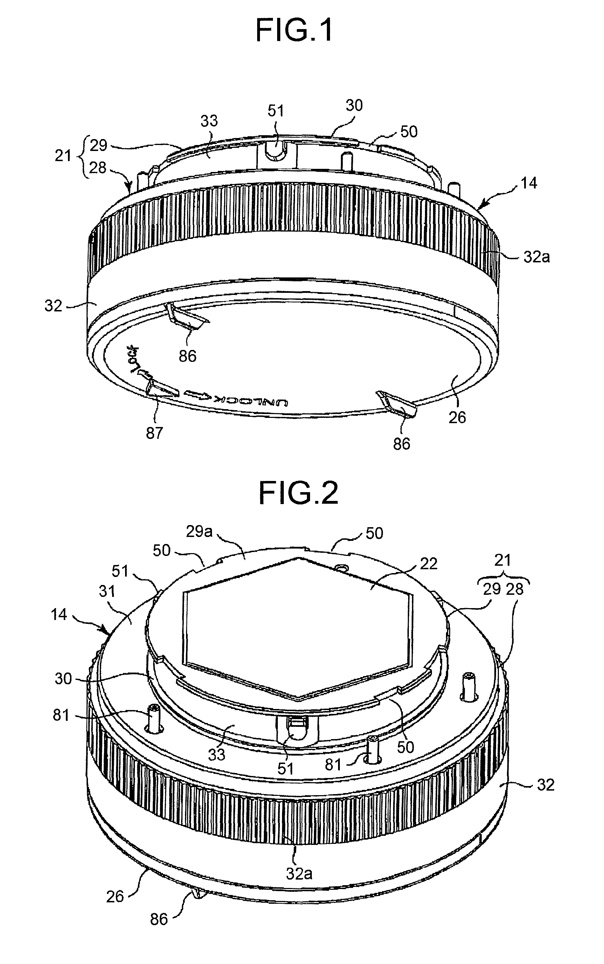

A lamp according to a first embodiment and a luminaire including the lamp are explained in detail with reference to Fig. 1 to Fig. 6.

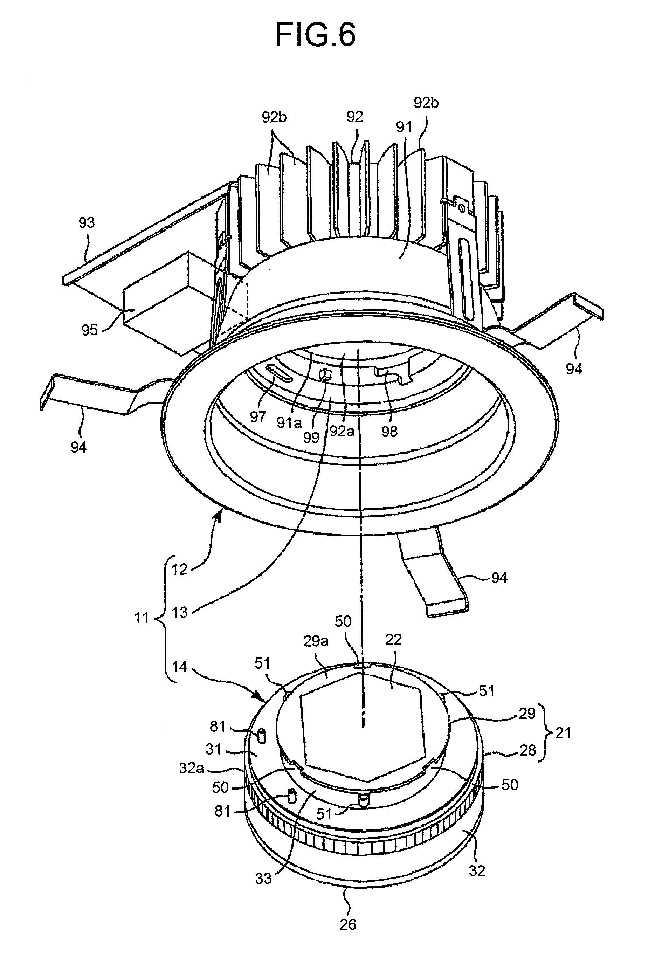

In Fig. 6, a luminaire 11 is used as, for example, a down light. The luminaire 11 is set to be embedded in a circular attachment hole opened in an indoor ceiling plate, which is a luminaire setting place.

The luminaire 11 includes a luminaire main body 12, a socket 13 and a lamp 14, or the like. The socket 13 is attached to the luminaire main body 12. The lamp 14 is detachably attached to the socket 13. Note that, since the luminaire 11 according to the first embodiment is the down light, a positional relation of the sections thereof is explained below with the up down direction set as a reference.

Firstly, the lamp 14 is explained. As shown in Figs. 1 to 4, the lamp 14 includes a lamp main body 21, a sheet 22, a light-emitting module 23, a reflecting member 24, a lighting device 25 and a lighting cover 26. A total luminous flux of the lamp 14 is, for example, 1100 lm to 1650 lm. Input power (power consumption) of the light-emitting module 23 is 20 W to 25 W.

The lamp main body 21 includes a case 28 and a cap member 29. An upper part of the case 28 and the cap member 29 form a cap section 30 having a predetermined standard size. The cap section 30 is a GH76p-type cap.

The case 28 is formed of synthetic resin having electric insulation. The case 28 includes an end wall section 31, a circumferential wall section 32, a cylinder section 33 and circuit-board supporting sections 37 and 38.

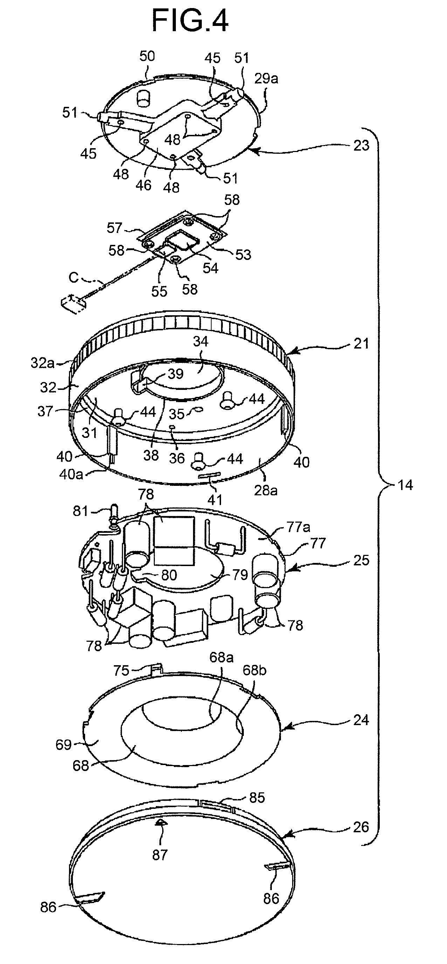

The end wall section 31 forms an upper wall of the case 28. The circumferential wall section 32 is cylindrical. The circumferential wall section 32 is bent downward from the circumferential edge of the end wall section 31. An opening 28a (see Fig. 4) at one end in the axial direction of the case 28 is formed at a distal end that forms the lower end of the circumferential wall section 32. The cylinder section 33 is smaller in diameter than the circumferential wall section 32. The cylinder section 33 is projected from the end wall section 31 in the opposite direction of the circumferential wall section 32, that is, the upward direction.

The circuit-board supporting sections 37 and 38 are provided between the end wall section 31 and the opening 28a. Specifically, the circuit-board supporting section 37 is provided on the inner side of a corner section formed by the end wall section 31 and the circumferential wall section 32. The circuit-board supporting section 37 is formed by an annular seat surface. The circuit-board supporting section 38 is provided in the inner side of the circuit-board supporting section 37. The circuit-board supporting section 38 is formed by a cylindrical wall section bent in the downward direction from the center of the end wall section 31. As a preferred example, a groove 39 for inserting an electric wire is formed in a part of the circuit-board supporting section 38 as shown in Fig. 4. A distal end forming the lower end of the circuit-board supporting section 38 and the seat surface forming the circuit-board supporting section 37 are located at the same height.

A hole 34 is opened in the center of the end wall section 31 located at the other end in the axial direction, i.e., in an upper part of the case 28. The hole 34 is circular and surrounded by the circuit-board supporting section 38. Note that the hole 34 and the circuit-board supporting section 38 may be separately provided. That is, the hole 34 and the circuit-board supporting section 38 may be respectively provided in arrangement that satisfies a concentric relation in which the diameters thereof are different from each other but the centers thereof coincide with each other.

As shown in Fig. 4, a plurality of screw through-holes 35 (only one of which is shown in the figure) and a pair of pin through-holes 36 (only one of which is shown in the figure) are opened in the end wall section 31 of the case 28. The screw through-holes 35 are provided closer to the hole 34. The pin through-holes 36 are provided closer to the circumferential wall section 32.

As shown in Fig. 4, a plurality of support sections 40, a plurality of attachment grooves 41 and an uneven section 32a are formed in the circumferential wall section 32 of the case 28.

Each of the support sections 40 is provided on the inner circumferential surface of the circumferential wall section 32 in order to support the reflecting member 24. One support section 40 includes a rib 40a for performing whirl-stop for the reflecting member 24. Each of the attachment grooves 41 is provided in the vicinity of the opening 28a. The uneven section 32a is provided to the upper outer circumferential surface of the circumferential wall section 32. The surface area of the circumferential wall section 32 is increased by the uneven section 32a.

The cap member 29 is formed of, for example, metal, ceramics, or resin excellent in heat conductivity. The cap member 29 according to the first embodiment is made of die-cast aluminum. The cap member 29 includes a base section 29a and a projection 46 integrally projected on the lower surface of the base section 29a.

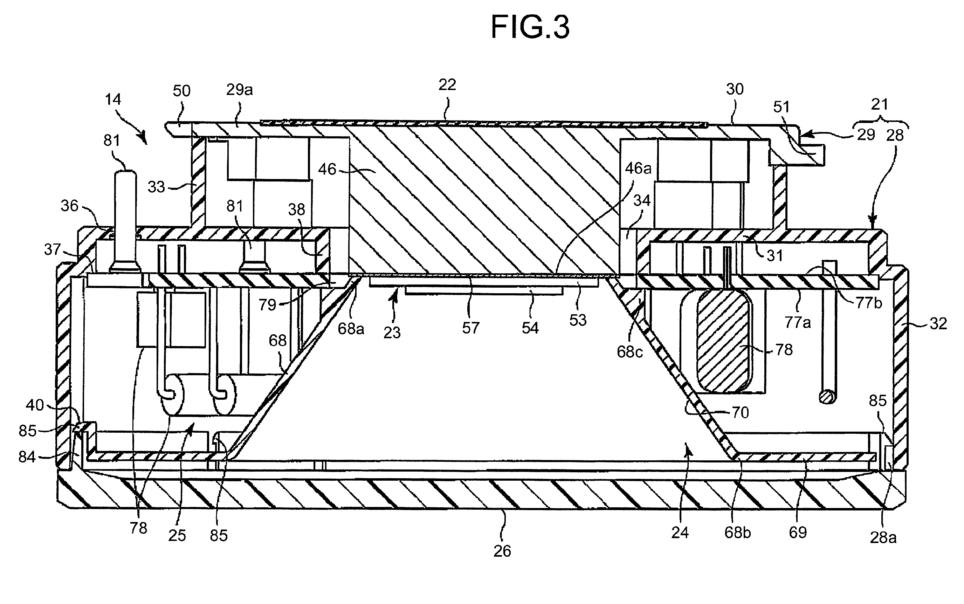

The base section 29a has a disc shape. The diameter of the base section 29a is lightly larger than the diameter of the cylinder section 33 of the case 28. Consequently, as shown in Fig. 3, the base section 29a is provided such that a circumferential section of the base section 29a is projected sideward from the outer circumferential surface of the cylinder section 33 to cover the cylinder section 33.

As shown in Fig. 4, a plurality of attachment holes 45 are formed on the lower surface of the cap member 29 and around the projection 46. Screws 44 are respectively screwed into the attachment holes 45 through the screw through-holes 35. According to the screwing of the screws 44, the cap member 29 is attached to the case 28 from above the case 28.

The distal end face of the projection 46 is located below the end wall section 31 and is at the same height as, for example, the seat surface, which forms the circuit-board supporting section 37, and the distal end of the circuit-board supporting section 38. The distal end face of the projection 46 forms an attachment surface for a module and is flat. The shape and the area of the attachment surface correspond to the shape and the area of the light-emitting module 23.

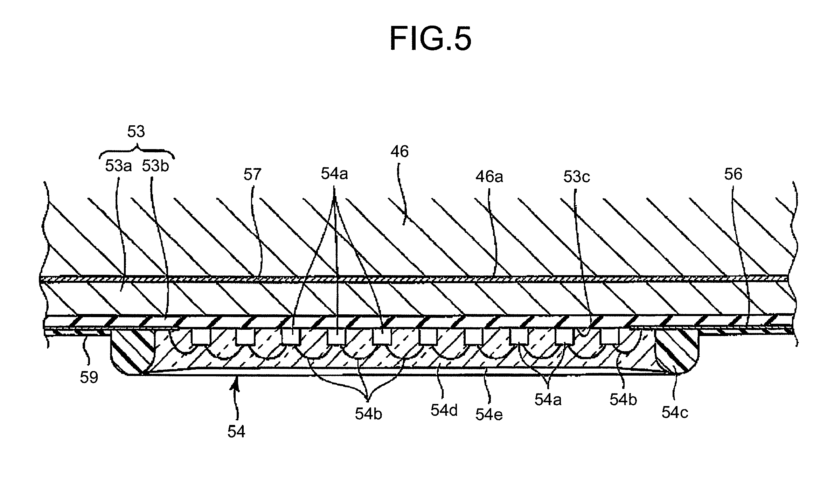

A plurality of attachment holes 48 for module fixing are provided in the projection 46 to be opened to the distal end face (the attachment surface) of the projection 46. As shown in Fig. 3 and Fig. 5, the distal end face of the projection 46 is covered with a sheet 57.

The sheet 57 is formed of a material excellent in heat conductivity, for example, a silicone resin sheet. Besides, the sheet 57 may be formed of foil of metal such as aluminum, tin, or zinc. When the sheet 57 is formed of the metal foil, deterioration due to heat less easily occurs and heat conductive performance can be maintained for a long period compared with the silicone resin sheet. The sheet 57 includes holes (not shown in the figure) opposed to the attachment holes 48. Note that the sheet 57 may be omitted.

The outside dimension of the projection 46 is smaller than the hole 34. The height (a projecting dimension) of the projection 46 from the base section 29a is set to at least a dimension for allowing the light-emitting module 23 to be inserted into the hole 34 of the case 28. In the first embodiment, the projection 46 is inserted into the hole 34 such that a distal end face 46a (see Fig. 3 and Fig. 5) of the projection 46 generally reaches the lower end of the hole 34.

A plurality of cutouts 50 and a plurality of keys 51 are formed in the circumferential section of the cap member 29 at equal intervals in the circumferential direction of the cap member 29. The plurality of cutouts 50 are formed between the keys 51. The keys 51 are projected further to the outer side than the circumferential edge of the base section 29a. In the first embodiment, three keys 51 and cutouts 50 are respectively provided. However, two or four or more keys 51 and cutouts 50 may be respectively provided.

The sheet 22 for heat conduction is attached to the upper surface (the back surface) of the base section 29a of the cap member 29. In a state in which the lamp 14 is attached to the luminaire main body 12, the sheet 22 is used for efficiently transmitting the heat of the lamp 14 from the lamp 14 to the luminaire main body 12.

The sheet 22 is polygonal, for example, hexagonal as shown in Fig. 2 but may be circular. The sheet 22 is formed in, for example, a two-layer structure of a sheet main body made of silicone resin and metal foil laminated on the sheet main body. The sheet main body has elasticity and is stuck to the base section 29a using an adhesive. The metal foil is formed of aluminum, tin, zinc, or the like. The frictional resistance of the surface of the metal foil is small compared with the frictional resistance of the sheet main body.

The light-emitting module 23 includes a substrate 53, a light-emitting section 54, an electric connector 55 and a resist layer 59 (see Fig. 5).

The heat conductivity of the substrate 53 is superior to the heat conductivity of a circuit board 77, which is described below. In order to obtain such performance, the substrate 53 according to the first embodiment is formed by laminating an insulating layer 53b on a surface of a metal base 53a as shown in Fig. 5.

The metal base 53a is made of, for example, iron, copper, or aluminum. The insulating layer 53b is thinner than the metal base 53a and is made of, for example, synthetic resin having electric insulation. Note that the substrate 53 may also be formed of a flat plate of ceramics excellent in heat conductivity instead of the substrate including the metal base 53a. The surface of the insulating layer 53b forms an element mounting surface 53c of the substrate 53. A wiring pattern 56 (see Fig. 5) made of metal foil is formed on the element mounting surface 53c.

The light-emitting section 54 is mounted on the substrate 53 and is smaller than the substrate 53. The light-emitting section 54 is formed by, for example, a COB (Chip On Board) -type light source. The light-emitting section 54 includes a plurality of light-emitting elements 54a made of a semiconductor, a plurality of bonding wires 54b, a frame member 54c and a sealing member 54d.

For example, LEDs (light emitting diodes) are used as the light-emitting elements 54a. In the first embodiment, bare chips that emit blue light, i.e., blue LEDs are used as the light-emitting elements 54a. The light-emitting elements 54a are die-bonded on the insulating layer 53b of the substrate 53, i.e., the element mounting surface 53c.

As the bonding wires 54b, metal thin wires, for example, thin wires of gold are used. The bonding wires 54b are wire-bonded to electrically connect the light-emitting elements 54a in series. At the same time, both ends of the light-emitting element column connected in series and the wiring pattern 56 are electrically connected by the bonding wires 54b.

The frame member 54c is made of synthetic resin having electric insulation and is formed on the insulating layer 53b. The light-emitting elements 54a and the bonding wires 54b are housed in the inner side of the frame member 54c. The sealing member 54d is filled on the inner side of the frame member 54c to embed the light-emitting elements 54a and the bonding wires 54b in order to seal the light-emitting elements 54a and the bonding wires 54b. The sealing member 54d is made of translucent synthetic resin, for example, transparent silicone resin. The surface of the sealing member 54d forms a light-emitting surface 54e from which light of the light-emitting section 54 is emitted.

A phosphor is mixed in the sealing member 54d. The phosphor is excited by a part of light emitted by the light-emitting elements 54a to emit light having a color different from the light emitted by the light-emitting elements 54a. In order to emit whitish illumination light from the light-emitting surface 54e, a phosphor excited by a part of blue light emitted by blue LEDs to emit yellow light is used.

Note that an SMD (Surface Mount Device) light-emitting section can also be used instead of the COB-type light-emitting section 54. The SMD-type light-emitting section is formed by a plurality of SMD packages mounted on the substrate 53. The SMD packages include LEDs configured by bare chips and connection terminals for mounting.

The resist layer 59 is electrically insulative and covers the element mounting surface 53c and the wiring pattern 56 of the substrate 53 on the outside of the light-emitting section 54. The electric connector 55 is disposed on the substrate 53 on the outer side of the light-emitting section 54. The electric connector 55 and a wiring pattern 23a are electrically connected.

The light-emitting module 23 is fixed to the projection 46 by a plurality of screws 58 (see Fig. 4) screwed into the plurality of attachment holes 48 through the light-emitting module 23. Consequently, the sheet 57 is sandwiched by the distal end face of the projection 46 and the metal base 53a that forms the rear surface of the substrate 53. Therefore, the light-emitting module 23 is arranged on the projection 46 in a state in which satisfactory heat conduction from the substrate 53 to the projection 46 of the cap member 29 is possible. Note that the substrate 53 of the light-emitting module 23 can also be bonded to the distal end face of the projection 46 using an adhesive instead of the screwing.

The reflecting member 24 includes a reflecting cylinder section 68 and a flange section 69 integrally formed by synthetic resin having electric insulation and a reflecting surface 70.

The reflecting cylinder section 68 includes a small-diameter opening at the upper end thereof and includes a large-diameter opening at the lower end thereof. A cross section in a direction orthogonal to the center axis of the reflecting cylinder section 68 is circular. The reflecting cylinder section 68 is formed in a taper shape gradually expanded in diameter from the small-diameter opening toward the large-diameter opening. That is, the reflecting cylinder section 68 is expanded in diameter stepwise or continuously toward the large-diameter opening side. The stepwise taper shape is a shape in which a plurality of parts having different diameters continue. A form in which the diameter of the reflecting cylinder section 68 continuously expands is not limited to the example shown in Fig. 3 and includes a form in which the reflecting cylinder section 68 bends to project to the inner side thereof and the diameter expands.

A small-diameter end 68a of the reflecting cylinder section 68 surrounds the small-diameter opening. The size of the small-diameter end 68a is enough to house the light-emitting section 54 of the light-emitting module 23. The small-diameter end 68a is smaller in diameter than the hole 34 of the case 28. The small-diameter end 68a is smaller than the shape of the projection 46 of the cap member 29. Further, an annular protrusion 68c is formed on the outer circumferential of the small-diameter end 68a. The annular protrusion 68c is set in contact with the edge of a center hole 79 of a circuit board 77 from a mounting surface 77a side.

A large-diameter end 68b of the reflecting cylinder section 68 surrounds the large-diameter opening. The large-diameter end 68b is larger in diameter than the hole 34.

The flange section 69 is bent from the large-diameter end 68b. A plurality of holding claws 75 are formed in the circumferential section of the flange section 69. The holding claws 75 are engaged with the support sections 40 of the case 28. Consequently, the flange section 69 is supported not to come off the opening edge section of the case 28. One holding claw 75 fits in the rib 40a of one support section 40. Consequently, a reflecting member 67 is whirl-stopped in the case 28.

The reflecting surface 70 is provided continuously from the inner circumferential surface of the reflecting cylinder section 68 to the lower surface (the front surface) of the flange section 69. The reflecting surface 70 is made of a white layer or a mirror surface having high light reflectance. The reflecting surface 70 made of the mirror surface may be formed by vapor-depositing aluminum or the like. In this case, by masking the outer circumferential section of the flange section 69 and forming the outer circumferential section as a non-vapor-deposited section, it is possible to improve the electric insulation in the outer circumferential section.

In a state in which the reflecting member 24 is attached to the case 28, the small-diameter end 68a is located to be in contact with the distal end face of the projection 46. Consequently, the light-emitting module 23 is housed in the reflecting cylinder section 68 through the small-diameter opening of the reflecting cylinder section 68.

The lighting device 25 includes the circuit board 77 and a plurality of circuit components 78 mounted on the circuit board 77. A power supply circuit including, for example, a rectifying circuit and a DC/DC converter is configured by the circuit board 77 and the circuit components 78. The rectifying circuit is a circuit configured to rectify and smooth the voltage of a commercial alternating-current power supply. The DC/DC converter includes a switching element and generates a high-frequency wave of several kHz to several hundred kHz according to switching of the element. Consequently, the lighting device 25 outputs direct-current power having a constant current.

A plate section of the circuit board 77 is made of synthetic resin having electric insulation. Therefore, a material cost of the circuit board 77 is lower than a material cost of the substrate 53 of the light-emitting module 23. The circuit board 77 includes a circuit pattern surface 77b formed on a surface of the plate section.

The circuit board 77 includes a center hole 79 in the center thereof. A cutout section 80 is formed in the circuit board 77 to face the center hole 79. The cutout section 80 is provided to correspond to the groove 39 of the case 28.

Both the outer circumferential shapes of the center hole 79 and the circuit board 77 are a circular shape. The center hole 79 has a diameter same as the diameter of the hole 34 of the case 28. Therefore, the shape of the center hole 79 is larger than the shape of the projection 46 and is naturally larger than the light-emitting module 23. The small-diameter end 68a of the reflecting cylinder section 68 penetrates into the inner side of the center hole 79.

A surface of the circuit board 77 on the opposite side of the circuit pattern surface 77b is the mounting surface 77a. Discrete components (the circuit components 78) including bar-like leads are disposed on the mounting surface 77a. The leads of the discrete components are projected from the circuit pattern surface 77b. The leads are soldered to the circuit pattern surface 77b.

Among the circuit components 78, at least one, preferably, all of components described below are disposed closer to the outer circumference of the circuit board 77. The components are a circuit component having large projection height from the circuit board 77, a circuit component having a large heat value, and a circuit component such as an electrolytic capacitor susceptible to heat.

An electric connector (not shown) is mounted on the mounting surface 77a. The connector is disposed in a position in the vicinity of the cutout section 80. At the same time, the electric connector is electrically connected to the electric connector 55 of the light-emitting module 23 through an electric wire C attached with a connector.

The lighting device 25 is housed in the case 28 with the circuit pattern surface 77b thereof opposed to the end wall section 31 of the case 28. The outer circumferential section of the circuit board 77 of the lighting device 25 is supported by the circuit-board supporting section 37. The inner circumferential section of the circuit board 77 is supported by the circuit-board supporting section 37. The circuit board 77 is fixed to the case 28 by screws (not shown). The circuit board 77 is arranged in parallel to the end wall section 31.

The mounting surface 77a of the circuit board 77 fixed to the case 28 is set closer to the opening 28a of the case 28 than the distal end of the projection 46. Further, the height position of the mounting surface 77a and the element mounting surface 53c of the substrate 53 of the light-emitting module 23 are at the same height. The same height means a total dimension of thickness dimensions of the light source module 23 and the circuit board 77. Further, the same height allows ranges deviating in the up down direction.

The circuit components 78 mounted on the mounting surface 77a are arranged in a space in the case 28 surrounded by the circumferential wall section 32 of the case 28, the reflecting member 67 and the circuit board 77.

A plurality of lamp pins 81 are pressed into the pin through-holes 36 of the case 28 and attached to the case 28. The lamp pins 81 are projected vertically to above the case 28. That is, the lamp pins 81 are projected vertically from the upper surface of the end wall section 31. The lamp pins 81 are electrically connected to the circuit board 77 using a lead wire (not shown). Note that, instead of using the lead wire, it is also possible to directly attach the lamp pins 81 to the circuit board 77 to stand and cause the lamp pins 81 to pierce through the end wall section 31 of the case 28.

The lighting cover 26 is formed in a disc shape from a material such as synthetic resin or glass having translucency and light diffusibility. The lighting cover 26 includes a fitting section 84 in the circumferential section of the lighting cover 26. The fitting section 84 is fit in the inner circumferential section of the circumferential wall section 32 of the case 28. A plurality of locking claws 85 are formed in the fitting section 84. The locking claws 85 are locked to the attachment grooves 41 of the circumferential wall section 32.

In a state in which the locking claws 85 are locked to the attachment grooves 41, the fitting section 84 and the support sections 40 sandwich the holding claws 75 of the reflecting member 67. Consequently, the reflecting member 24 is held. Note that it is also possible to sandwich the reflecting member 24 using the fitting section 84 of the lighting cover 26 and the circuit board 77 and hold the reflecting member 24 without using the support sections 40 of the case 28. In this case, the support sections 40 may be used as ribs for reinforcement.

As shown in Fig. 1 and the like, a pair of finger catching sections 86 is protrudingly provided in the circumferential section of the lower surface (the front surface) of the lighting cover 26. The finger catching sections 86 are formed to facilitate attachment operation and detachment operation for the lamp 14 to and from the luminaire main body 12. The shape of the finger catching sections 86 is arbitrary. However, it is preferable that the finger catching sections 86 are configured to be less conspicuous not to spoil the appearance of the lamp 14, not to hinder luminous intensity distribution, and to facilitate operation in attaching and detaching the lamp 14. Further, for example, a triangular mark 87 indicating a lamp mounting position on the luminaire main body 12 is formed in the circumferential section of the lower surface of the lighting cover 26.

As shown in Fig. 6, the luminaire main body 12 includes a reflector 91, a thermal radiator 92, an attachment plate 93 and a plurality of attachment springs 94.

The reflector 91 is made of metal, for example, an aluminum alloy. The reflector 91 is opened at the lower end and gradually expanded in diameter toward the opening. A circular opening section 91a is formed at the top of the reflector 91. The thermal radiator 92 is also made of metal, for example, an aluminum alloy. The thermal radiator 92 is attached to an upper part of the reflector 91. The thermal radiator 92 includes a contact section 92a. The contact section 92a faces the inside of the reflector 91 through the opening section 91a.

The attachment plate 93 is also made of metal, for example, an aluminum alloy. The attachment plate 93 is attached to an upper part of the thermal radiator 92 and projected to a side of the thermal radiator 92. A terminal block 95 is attached to the attachment plate 93. The attachment springs 94 are leaf springs and used for attaching the luminaire main body 12 to an indoor ceiling. The attachment springs 94 are attached to the thermal radiator 92.

The socket 13 is attached to the lower surface of the top of the reflector 91. The socket 13 is formed in an annular shape in a size for surrounding the opening section 91a. A pair of connection holes 97 is formed in the socket 13 (in Fig. 6, only one of the connection holes 97 is shown and the other is hidden by the thermal radiator 92). The connection holes 97 extend in the circumferential direction of the socket 13 and have a long hole shape. Terminals (not shown) are respectively arranged on the inner sides of the pair of connection holes 97. The commercial alternating-current power is supplied to the terminals through the terminal block 95.

On the inner circumferential surface of the socket 13, a plurality of attachment grooves 98 and a plurality of attachment protrusions 99 are formed at equal intervals and alternately in the circumferential direction of the socket 13. The attachment grooves 98 and the attachment protrusions 99 are provided to enable attachment and detachment of the lamp 14 to and from the luminaire main body 12. The attachment grooves 98 and the attachment protrusions 99, and the keys 51 and the cutouts 50 of the lamp 14 correspond to each other.

The keys 51 are engaged with the attachment grooves 98 and the cutouts 50 are engaged with the attachment protrusions 99, whereby the lamp 14 is attached to the socket 13. To engage the cutouts 50 with the attachment protrusions 99, the lamp 14 inserted into the luminaire main body 12 may be turned in one direction. To disengage the attachment protrusions 99 from the cutouts 50, the lamp 14 may be turned in the opposite direction of the direction in attaching the lamp 14.

A procedure for assembling the lamp 14 is explained.

The sheet 22 is attached to the upper surface of the base section 29a of the cap member 29. The distal end face of the projection 46 of the cap member 29 is covered with the sheet 57. The light-emitting module 23 is screwed to the projection 46 across the sheet 57. The electric wire C is connected to the electric connector 55 of the light-emitting module 23. The electric wire C is led into the case 28 through the hole 34 of the case 28. In this state, the cap member 29 is screwed to the upper part of the case 28.

Thereafter, the lamp pins 81 are pressed into the case 28 and the lighting device 25 is housed in the case 28. At this point, in housing the lighting device 25 in the case 28, the electric wire C is inserted through the groove 39 and the electric wire C is connected to the electric connector of the circuit board 77. At the same time, the outer circumferential section of the circuit board 77 of the lighting device 25 is fit in the circuit-board supporting section 37 of the case 28 and supported. The inner circumferential section of the circuit board 77 is brought into contact with the circuit-board supporting section 38 and supported.

Subsequently, the reflecting member 24 is housed in the case 28 through the opening 28a of the case 28. At this point, the small-diameter end 68a of the reflecting cylinder section 68 is inserted into the center hole 79 of the circuit board 77. Consequently, the small-diameter end 68a is set in contact with or near the distal end face circumferential section of the projection 46 of the cap member 29 inserted into the hole 34 of the case 28. At the same time, the light-emitting module 23 is housed in the inner side of the small-diameter end 68a. Moreover, the holding claws 75 of the reflecting member 67 are opposed to the support sections 40 of the case 28.

In this state, the lighting cover 26 is fit in the opening 28a of the case 28. The locking claws 85 of the lighting cover 26 are locked to the attachment grooves 41 of the case 28. According to the locking of the locking claws 85 to the attachment grooves 41, the fitting section 84 of the lighting cover 26 comes into contact with the holding claws 75 of the reflecting member 67. The fitting section 84 is pressed against the support sections 40. Consequently, the holding claws 75 are sandwiched by the fitting section 84 and the support sections 40. At the same time, a circuit-board pressing section 74 of the reflecting member 67 presses the circuit board 77 against the circuit-board supporting sections 37 and 38. Consequently, the circuit board 77 is sandwiched by the circuit-board pressing section 74 and the circuit-board supporting sections 37 and 38.

Therefore, the lighting cover 26 is attached to the case 28, whereby the circuit board 77 of the lighting device 25 and the reflecting member 67 housed in the case 28 are retained in a state in which the reflecting member 67 is sandwiched by the case 28 and the lighting cover 26.

A procedure for causing the luminaire 11 to support the lamp 14 is explained.

The lamp 14 is inserted into the socket 13 from the lower end opening of the luminaire main body 12. That is, the cap member 29 of the lamp 14 is inserted into the inner side of the socket 13. Consequently, the cutouts 50 of the cap member 29 are inserted through the attachment protrusions 99 of the socket 13. Similarly, the keys 51 of the cap member 29 are inserted through the attachment grooves 98 of the socket 13. At the same time, the lamp pins 81 of the lamp 14 are inserted through the connection holes 97 of the socket 13. The sheet 22 attached to the cap member 29 is brought into contact with the contact section 92a of the thermal radiator 92.

Subsequently, the lamp 14 is rotated a predetermined angle in a state in which the lamp 14 is pressed against the thermal radiator 92. When this rotating operation is performed, an operator can turn the lamp 14 by putting a finger on the finger catching section 86 projected on the lower surface of the lighting cover 26. Therefore, even if a space into which the finger of the operator is inserted is not secured between the circumferential surface of the lamp 14 and the inner circumferential surface of the luminaire main body 12, it is possible to easily turn the lamp 14.

The lamp 14 is rotated in the predetermined direction, whereby the cutouts 50 of the cap member 29 come off the attachment protrusions 99 of the socket 13 and the circumferential section of the cap member 29 is caught by the attachment protrusions 99. At the same time, the keys 51 of the cap member 29 come off the attachment grooves 98 and are caught by the socket 13. Therefore, the lamp 14 is attached to the socket 13.

Further, according to such attachment of the lamp 14, the lamp pins 81 of the lamp 14 move in the connection holes 97 of the socket 13. Consequently, since the lamp pins 81 are brought into contact with terminals arranged in the connection holes 97, the lamp 14 is connected in a state in which electric power can be supplied to the lamp 14.

When the lamp 14 is supported by the socket 13 as explained above, the base section 29a of the cap member 29 of the lamp 14 is retained in a state in which the base section 29a is set in close contact with the contact section 92a of the thermal radiator 92 via the sheet 22 bonded to the base section 29a. Therefore, heat generated by the light-emitting element 54a in emitting light according to the power supply to the lamp 14 can be conducted through the sheet 57, the projection 46, the base section 29a and the sheet 22 and efficiently emitted to the luminaire main body 12.

To detach the lamp 14 from the luminaire main body 12, firstly, the lamp 14 is rotated in the opposite direction of the direction in attaching the lamp 14 to the luminaire main body 12. According to the rotation of the lamp 14, the keys 51 of the cap member 29 are moved on the attachment protrusions 99 of the socket 13. At the same time, the keys 51 of the cap member 29 are moved to positions where the keys 51 come off the attachment grooves 98 of the socket 13. Subsequently, the lamp 14 is moved downward. According to the movement of the lamp 14, the lamp pins 81 come off the connection holes 97 of the socket 13. At the same time, the cutouts 50 of the cap member 29 come off the attachment protrusions 99 of the socket 13. The keys 51 of the cap member 29 come off the attachment grooves 98 of the socket 13. Further, the cap member 29 comes off the inner side of the socket 13. The lamp 14 is removed from the socket 13.

Next, lighting and thermal radiation of the lamp 14 are explained.

Electric power is supplied to the lighting device 25 from a power supply line through the terminal block 95, the terminal of the socket 13 and the lamp pins 81 of the lamp 14. Consequently, a direct-current output for lighting is supplied from the lighting device 25 to the light-emitting elements 54a of the light-emitting module 23. The light-emitting elements 54a are caused to emit light (lit). Therefore, whitish illumination light is emitted downward from the light-emitting surface 54e of the light-emitting module 23. The illumination light travels on the inner side of the reflecting cylinder section 68 and is transmitted through the lighting cover 26 and emitted to below the luminaire main body 12.

In the illumination light emitted from the light-emitting surface 54e, light made incident on the reflecting surface 70 of the reflecting cylinder section 68 is reflected downward on the reflecting surface 70 and transmitted through the lighting cover 26. Note that light reflected upward on the inner surface of the lighting cover 26 further on the outer side than the large-diameter opening of the reflecting cylinder section 68 is reflected on the surface of the flange section 69 of the reflecting member 24 toward the lighting cover 26.

As explained above, the illumination light emitted from the light-emitting module 23 is reflected on the reflecting member 24 toward the lower end opening of the case 28. Since a reflection loss on the reflecting member 24 is prevented as described below, it is possible to improve extracting efficiency of light from the lamp 14 to below the lamp 14.

That is, the distal end of the projection 46 included in cap member 29 is inserted into the hole 34 of the case 28. The light-emitting module 23 is attached to the distal end face of the projection 46. Consequently, the light-emitting module 23 projects to the opening 28a of the case 28 away from the base section 29a of the cap member 29. In other words, the light-emitting surface 54e of the light-emitting module 23 is disposed between the small-diameter opening and the large-diameter opening of the reflecting cylinder section 68 and set close to the large-diameter opening that forms an emission port of the reflecting cylinder section 68. Therefore, extracting efficiency of light emitted from the light-emitting module 23 is improved.

At the same time, the small-diameter end 68a of the reflecting cylinder section 68 surrounds the light-emitting module 23. However, the small-diameter end 68a is not inserted into the hole 34 of the case 28 and generally reaches the distal end face of the projection 46. Moreover, the reflecting cylinder section 68 is expanded in diameter starting from the small-diameter end 68a. Consequently, illumination light emitted from the light-emitting surface 54e and made incident on the oblique inner surface of the reflecting cylinder section 68 can be surely reflected toward the large-diameter opening that forms the emission port in the reflecting cylinder section 68. Consequently, extracting efficiency of light emitted from the light-emitting module 23 is improved.

Note that, in a configuration (a comparative example) in which the reflecting cylinder section 68 pierces through the hole 34 of the case 28, a cylindrical end of the reflecting member 24 arranged between the hole 34 and the base section 29a of the cap member 29 is formed in a substantially straight cylinder structure. Illumination light made incident on the inner surface at this substantially straight cylindrical end is less easily reflected toward the emission port of the reflecting cylinder section 68. Therefore, extracting efficiency of light in the comparative example is lower than the extracting efficiency of light in the first embodiment.

The diameter of the small-diameter end 68a of the reflecting cylinder section 68 is larger than the diameter of the cylindrical end in the comparative example. The small-diameter end 68a houses the light-emitting module 23 having a predetermined size. Therefore, it is possible to house the light-emitting module 23 in the inner side of the small-diameter end 68a without increasing the diameter of the reflecting cylinder section 68. Consequently, there is an advantage that the diameter of the lamp 14 does not have to be increased.

On the other hand, in the comparative example as described above in which the reflecting cylinder section pierces through the hole 34 of the case 28, the distal end opening of the cylindrical end is set close to the base section 29a of the cap member 29. The light-emitting module having the predetermined size is housed in the distal end opening. Therefore, it is necessary to increase the diameter of the reflecting cylinder section. The reflecting member is increased in size. Accordingly, the lamp 14 is increased in size.

During lighting of the lamp 14, the light-emitting elements 54a included in the light-emitting module 23 emit heat. The substrate 53 including the metal base 53a is connected to the projection 46 of the cap member 29 made of metal to be capable of conducting heat to the projection 46. Therefore, the heat of the light-emitting elements 54a is efficiently conducted to the projection 46 mainly through the sheet 57. Further, the heat of the projection 46 is spread in the base section 29a wider than the projection 46 and conducted to the thermal radiator 92 of the luminaire main body 12, with which the sheet 22 is set in close contact, through the sheet 22. The heat of the thermal radiator 92 is emitted to the air from thermal radiation fins 92a included in the thermal radiator 92.

According to such thermal radiation, a temperature rise of the light-emitting elements 54a is suppressed. Therefore, it is possible to suppress a decrease in the life, deterioration in light-emitting efficiency, and the like of the light-emitting elements 54a.

Note that a part of the heat conducted from the lamp 14 to the thermal radiator 92 is also conducted to the luminaire main body 12, the plurality of attachment springs 94 and the attachment plate 93 and emitted to the air. The heat emitted by the lighting device 25 is transmitted to the case 28 and the lighting cover 26 and emitted to the air from the case 28 and the lighting cover 26.

### Second Embodiment

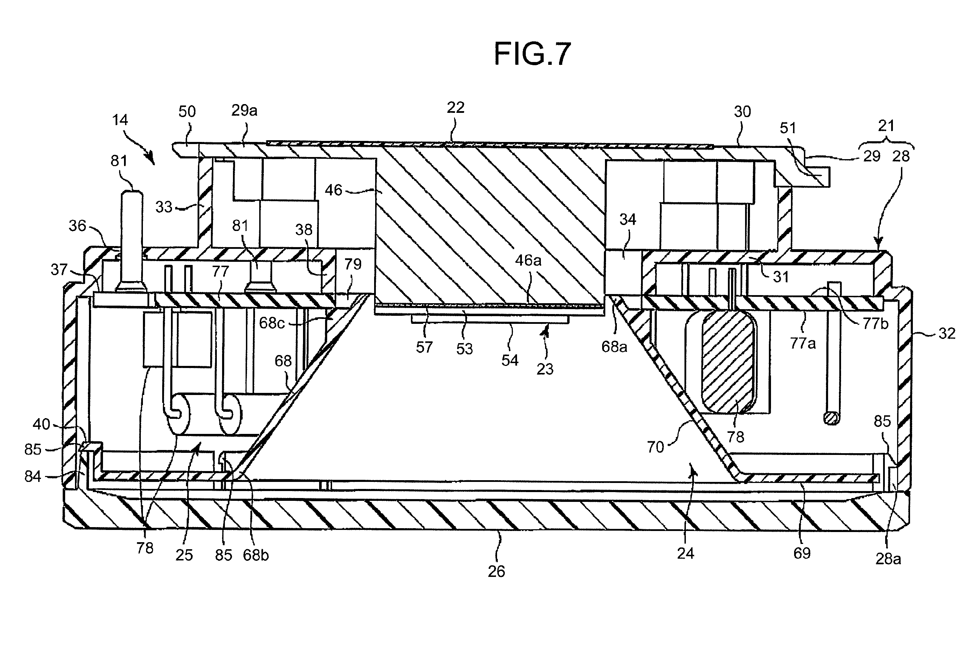

Fig. 7 shows a second embodiment. The second embodiment is different from the first embodiment in components as described below. The other components are the same as those in the first embodiment. Therefore, components attaining functions same as or similar to those in the first embodiment are denoted by reference numerals and signs same as those in the first embodiment and explanation of the components is omitted.

In the second embodiment, the distal end of the projection 46 of the cap member 29 is inserted into the hole 34 of the case 28 and pierces through the hole 34. Therefore, the distal end of the projection 46 is set closer to the opening 28a of the case 28 than the circuit-board supporting sections 37 and 38. At the same time, the element mounting surface 53c of the substrate 53 included in the light-emitting module 23 is also set closer to the opening 28a of the case 28 than the mounting surface 77a of the circuit board 77.

The size of the small-diameter opening formed by the small-diameter end 68a of the reflecting cylinder section 68 is enough to house the distal end of the projection 46. The distal end of the projection 46 is housed in the inner side of the reflecting cylinder section 68 through the small-diameter opening. Therefore, the light-emitting module 23 is also housed in the inner side of the reflecting cylinder section 68. Therefore, the light-emitting surface 54e of the light-emitting module 23 is set closer to the opening 28a of the case 28 than the circuit-board supporting sections 37 and 38 and the mounting surface 77a of the circuit board 77.

In the lamp 14 and the luminaire 11 in the second embodiment, components other than those described above are the same as the components in the first embodiment including the components not shown in Fig. 7. Therefore, in the second embodiment, as in the first embodiment, the problems are solved and it is possible to provide the lamp 14 capable of improving extracting efficiency of light emitted from the light-emitting module 23 while securing thermal radiation performance of the light-emitting elements and the luminaire 11 including the lamp 14.

### Third Embodiment

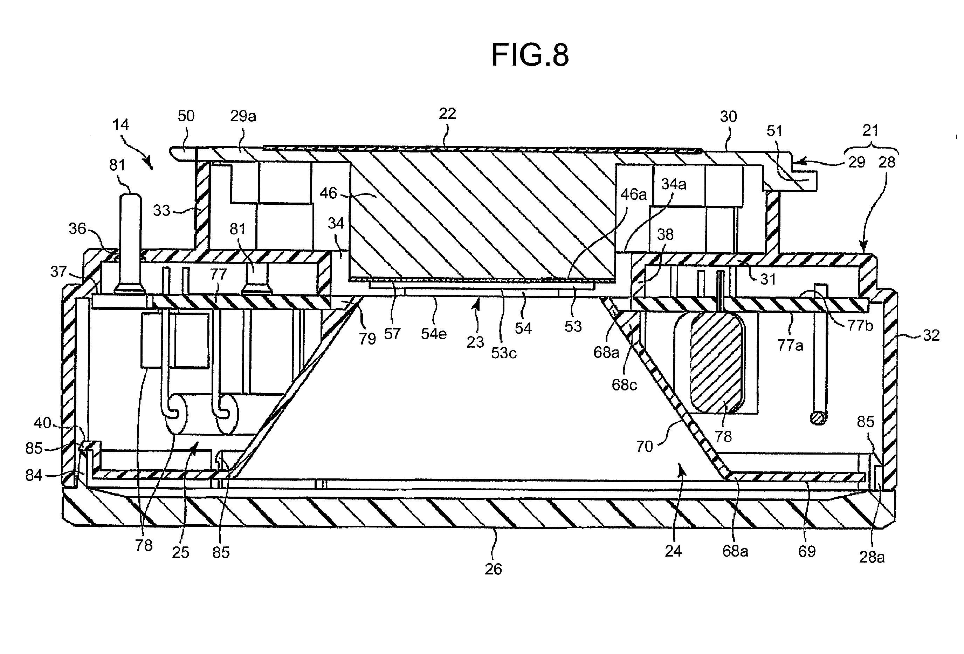

Fig. 8 shows a third embodiment. The third embodiment is different from the first embodiment in components as described below. The other components are the same as those in the first embodiment. Therefore, components attaining functions same as or similar to those in the first embodiment are denoted by reference numerals and signs same as those in the first embodiment and explanation of the components is omitted.

In the third embodiment, projection height of the projection 46 of the cap member 29 is smaller than the projection height of the projection 46 in the first embodiment. The distal end of the projection 46 is inserted into the hole 34 without piercing through the hole 34 of the case 28.

Therefore, the distal end of the projection 46 is set closer to the rear surface side of the cap member 29, i.e., the base section 29a than the circuit-board supporting sections 37 and 38, and the circuit board 77. Consequently, the light-emitting surface 54e of the light-emitting module 23 attached to the distal end of the projection 46 to be capable of conducting heat to the distal end is set further away from the opening 28a of the case 28 than the circuit-board supporting sections 37 and 38, and the mounting surface 77a. Consequently, the element mounting surface 53c further projects to one end side of the case 28 than an end 34a of the hole 34 close to the cap member 29 and is set further away from the opening 28a than the mounting surface 77a of the circuit board 77.

At the same time, the light-emitting module 23 attached to the distal end of the projection 46 to be capable of conducting heat to the distal end is disposed in the hole 34 of the case 28. Moreover, the height of the light-emitting surface 54e of the light-emitting module 23 is the same as the height of the circuit-board supporting sections 37 and 38, the circuit pattern surface 77b of the circuit board 77 and the small-diameter opening of the reflecting cylinder section 68. Therefore, in the third embodiment, the light-emitting module 23 is disposed to continue to the upper side of the small-diameter opening of the reflecting cylinder section 68.

In the lamp 14 and the luminaire 11 in the third embodiment, components other than those described above are the same as the components in the first embodiment including the components not shown in Fig. 8. Therefore, in the third embodiment, as in the first embodiment, the problems are solved and it is possible to provide the lamp 14 capable of improving extracting efficiency of light emitted from the light-emitting module 23 while securing thermal radiation performance of the light-emitting elements and the luminaire 11 including the lamp 14.

### Fourth Embodiment

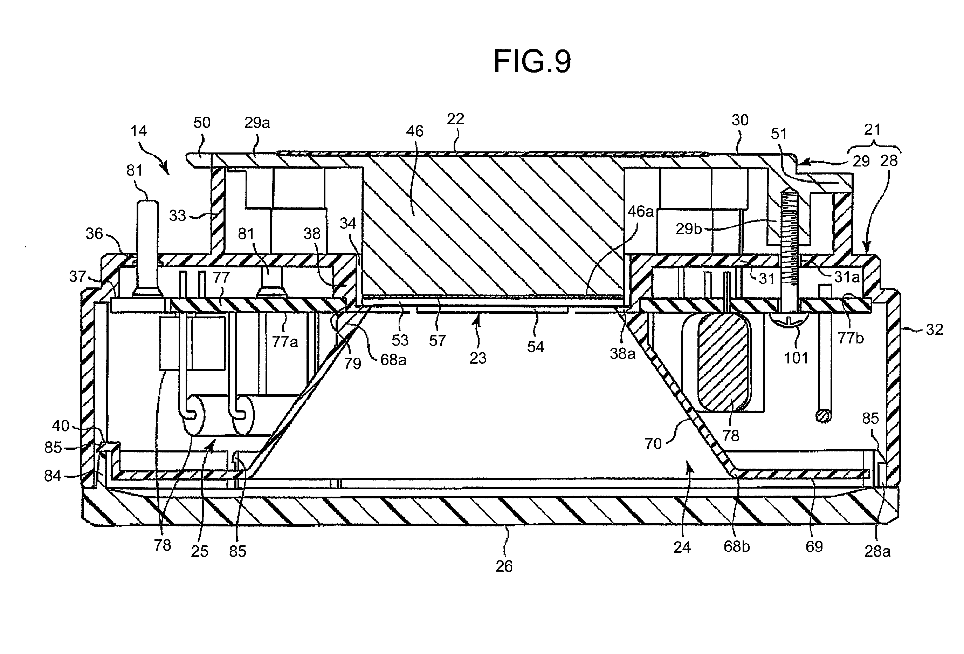

Fig. 9 shows a fourth embodiment. The fourth embodiment is different from the first embodiment in components as described below. The other components are the same as those in the first embodiment. Therefore, components attaining functions same as or similar to those in the first embodiment are denoted by reference numerals and signs same as those in the first embodiment and explanation of the components is omitted.

The fourth embodiment is different from the first embodiment in a configuration in which the light-emitting module 23 is held on the projection 46 of the cap member 29.

That is, an annular part where the hole 34 of the case 28 is formed, i.e., the circuit-board supporting section 38 on the inner side includes a pressing section 38a integrally. The pressing section 38a is projected into the hole 34 of the case 28 continuously without a break in the circumferential direction. The lower end of the pressing section 38a is a plane. The upper end of the small-diameter end 68a of the reflecting cylinder section 68 is set in contact with the lower end of the pressing section 38a. The pressing section 38a overlaps the circumferential section of the substrate 53 included in the light-emitting module 23 and sandwiches the circumferential section between the pressing section 38a and the projection 46. The small-diameter end 68a also functions as the annular protrusion explained in the first embodiment.

A plurality of screw receiving sections 29b (only one of which is shown in the figure) are formed in the base section 29a of the cap member 29. A plurality of through-holes 31a opposed to the screw receiving sections 29b are formed in the end wall section 31 of the case 28. The circuit board 77 of the lighting device 25 is coupled to the cap member 29 by a plurality of screws 101 (only one of which is shown in the figure). The screws 101 are screwed into the screw receiving sections 29b through the circuit board 77 and the through holes 31a.

According to tightening of the screws 101, the circuit board 77 is fixed to the case 28 in close contact with the circuit-board supporting sections 37 and 38. At the same time, the case 28 and the cap member 29 are coupled. According to this fixing, the inner circumferential section of the circuit board 77 is moved to the base section 29a side via the circuit-board supporting section 37 with the pressing section 38a. Consequently, the base section 29a comes into close contact with the circumferential section of the substrate 53 of the light-emitting module 23. The circumferential section is sandwiched between the screw receiving sections 29b and the distal end surface of the projection 46. That is, the light-emitting module 23 is fixed on the projection 46. According to this fixing, the sheet 57 is sandwiched by the projection 46 and the substrate 53.

In the lamp 14 and the luminaire 11 in the fourth embodiment, components other than those described above are the same as the components in the first embodiment including the components not shown in Fig. 9. Therefore, in the fourth embodiment, as in the first embodiment, the problems are solved and it is possible to provide the lamp 14 capable of improving extracting efficiency of light emitted from the light-emitting module 23 while securing thermal radiation performance of the light-emitting elements and the luminaire 11 including the lamp 14.

Moreover, in the fourth embodiment, the annular circuit-board supporting section 38 including the pressing sections 38a is provided in a state in which the annular circuit-board supporting section 38 partitions the light-emitting module 23 and the circuit board 77. Therefore, there is an advantage that it is possible to improve electric insulation between the light-emitting module 23 and the circuit board 77.

### Fifth Embodiment

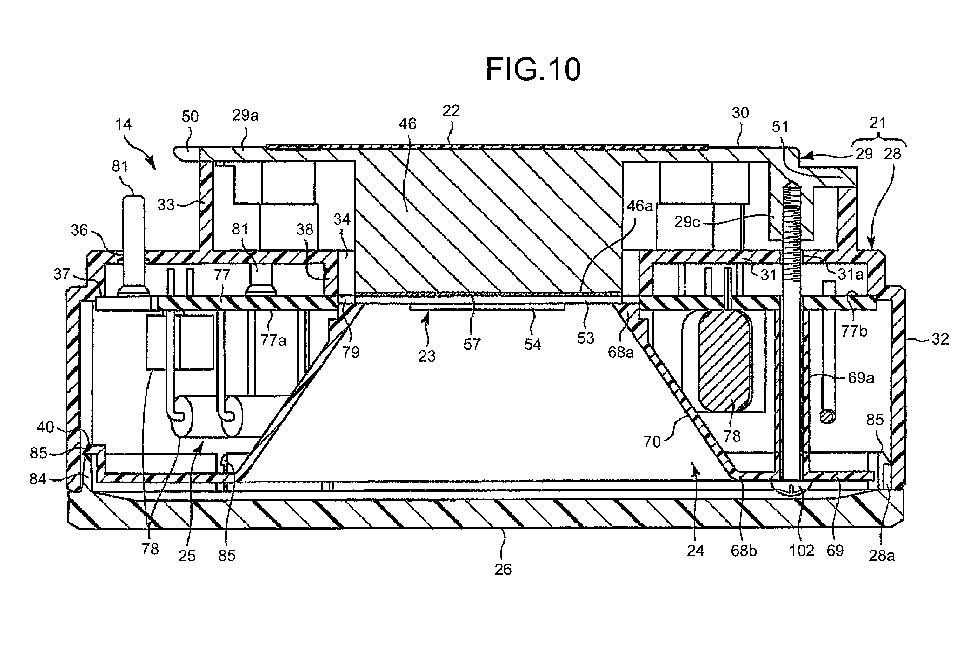

Fig. 10 shows a fifth embodiment. The fifth embodiment is different from the first embodiment in components as described below. The other components are the same as those in the first embodiment. Therefore, components attaining functions same as or similar to those in the first embodiment are denoted by reference numerals and signs same as those in the first embodiment and explanation of the components is omitted.

The fifth embodiment is different from the first embodiment in a configuration in which the light-emitting module 23 is held on the projection 46 of the cap member 29.

That is, the reflecting cylinder section 68 has length for setting the small-diameter end 68a thereof in contact with the circumferential lower surface of the substrate 53 of the light-emitting module 23. In the fifth embodiment, the annular protrusion 68c formed on the outer surface of the small-diameter end 68a is a protrusion for reinforcement of the small-diameter end 68a and is formed not to be in contact with the inner circumferential section lower surface of the circuit board 77.

A plurality of screw receiving sections 29b (only one of which is shown in the figure) are formed in the base section 29a of the cap member 29. The plurality of through-holes 31a opposed to the screw receiving sections 29b are formed in the end wall section 31 of the case 28. Further, through-holes 77c opposed to the through-holes 31a are formed in the circuit board 77 of the lighting device 25.

A plurality of cylinder sections 69a (only one of which is shown in the figure) reaching the mounting surface 77a of the circuit board 77 are integrally formed in the flange section 69 of the reflecting member 24. The reflecting member 24 is coupled to the cap member 29 by screws 102 respectively inserted through the cylinder sections 69a. The screws 102 are screwed into the screw receiving sections 29b through the through-holes 77c and 31a.

According to tightening of the screws 102, the circuit board 77 is fixed to the case 28 in close contact with the circuit-board supporting sections 37 and 38. At the same time, the reflecting member 24 is set close to the cap member 29 side and fixed. According to the fixing of the reflecting member 24, the small-diameter end 68a of the reflecting member 24 comes into close contact with the circumferential section of the substrate 53 of the light-emitting module 23. The circumferential section is sandwiched between the small-diameter end 68a and the distal end face of the projection 46. That is, the light-emitting module 23 is fixed on the projection 46.

At this point, the cylinder section 69a is sandwiched between the flange section 69 of the reflecting member 24 and the circuit board 77. Therefore, even if the screws 102 are excessively tightened, the flange section 69 is prevented from being deformed. Note that the sheet 57 is sandwiched between the projection 46 of the cap member 29 and the substrate 53 of the light-emitting module 23.

In the lamp 14 and the luminaire 11 in the fifth embodiment, components other than those described above are the same as the components in the first embodiment including the components not shown in Fig. 10. Therefore, in the fifth embodiment, as in the first embodiment, the problems are solved and it is possible to provide the lamp 14 capable of improving extracting efficiency of light emitted from the light-emitting module 23 while securing thermal radiation performance of the light-emitting elements and the luminaire 11 including the lamp 14.

While certain embodiments have been described, these embodiments have been presented by way of example only, and are not intended to limit the scope of the inventions. These novel embodiments can be carried out in a variety of other forms. Various omissions, substitutions, changes, and the like can be made without departing from the spirit of the inventions. These embodiments and the modifications and the like of the embodiments are included in the scope and the gist of the inventions and included in the scope of the inventions described in the claims and equivalents of the inventions.

## Claims

1. A lamp comprising:
a lamp main body including, a case including an opening at one end and a hole in an other end center, and a cap member integrally including a projection insertable into the hole of the case and attached to the case;
a lighting device including a circuit board and housed in the case;
a light-emitting module including a substrate superior to the circuit board in heat conductivity and a light-emitting element mounted on the substrate and caused to emit light by the lighting device, the light-emitting module being arranged on the projection to be capable of transmitting heat to the projection; and
a reflecting member including a reflecting cylinder section including a small-diameter opening and a large-diameter opening, a diameter of the reflecting cylinder section gradually expanding from the small-diameter opening to the large-diameter opening, the reflecting member being housed in the case and reflecting light emitted from the light-emitting module to an outside of the lamp main body.

2. The lamp according to claim 1, wherein an element mounting surface of the substrate of the light-emitting module and a mounting surface of the circuit board are at same height.

3. The lamp according to claim 1, wherein an element mounting surface of the substrate of the light-emitting module is set closer to the opening of the case than a mounting surface of the circuit board.

4. The lamp according to claim 1, wherein an element mounting surface of the substrate of the light-emitting module projects further to the one end side of the case than an end of the hole close to the cap member and is further away from the opening of the case than a mounting surface of the circuit board.

5. The lamp according to claim 1, wherein the case includes a circuit-board supporting section configured to support the circuit board, and a light-emitting surface of the light-emitting module is set closer to the opening of the case than the circuit-board supporting section.

6. The lamp according to claim 1, wherein a light-emitting surface of the light-emitting module is arranged between the small-diameter opening and the large-diameter opening.

7. The lamp according to any one of claim 1 to claim 6, wherein the case integrally includes an annular pressing section projecting into the hole of the case, a circumferential section of the substrate of the light-emitting module is sandwiched by the pressing section and the projection, and the case and the cap member are coupled by a fastener.

8. The lamp according to any one of claim 1 to claim 6, wherein a circumferential section of the substrate of the light-emitting module is sandwiched by a small-diameter end of the reflecting cylinder section surrounding the small-diameter opening and the projections, and the reflecting member is fastened by a fastener.

9. A luminaire comprising:
a luminaire main body including a contact section;
a socket attached to the luminaire main body; and
a lamp attached to the socket, wherein
the lamp includes:
a lamp main body including, a case including an opening at one end and a hole in an other end center, and a cap member integrally including a projection insertable into the hole of the case, attached to the case, and set in contact with the contact section;
a lighting device including a circuit board and housed in the case;
a light-emitting module including a substrate superior to the circuit board in heat conductivity and a light-emitting element mounted on the substrate and caused to emit light by the lighting device, the light-emitting module being arranged on the projection to be capable of transmitting heat to the projection; and
a reflecting member including a reflecting cylinder section including a small-diameter opening and a large-diameter opening, a diameter of the reflecting cylinder section gradually expanding from the small-diameter opening to the large-diameter opening, the reflecting member being housed in the case and reflecting light emitted from the light-emitting module to an outside of the lamp main body.
